Europäisches Patentamt

European Patent Office

Office européen des brevets

(11) Veröffentlichungsnummer: **0 377 094**

**A1**

# (12) EUROPÄISCHE PATENTANMELDUNG

(21) Anmeldenummer: **89119997.8**

(22) Anmeldetag: **27.10.89**

(51) Int. Cl.5: **G01R 31/00, G01R 31/36**

(30) Priorität: **27.10.88 DE 3836569**

(43) Veröffentlichungstag der Anmeldung:
**11.07.90 Patentblatt 90/28**

(84) Benannte Vertragsstaaten:
**DE FR GB IT**

(71) Anmelder: **Spies, Martin**
**Am Berg 4**
**D-8068 Pfaffenhofen(DE)**

(72) Erfinder: **Spies, Martin**
**Am Berg 4**
**D-8068 Pfaffenhofen(DE)**

(74) Vertreter: **Schneider, Jochen, Dr. et al**
**Lothstr. 1/111**
**D-8000 München 2(DE)**

(54) **Vorrichtung zum Prüfen des Betriebszustands eines elektrischen Energiespeichers von Kraftfahrzeugen und Verfahren zur Verwendung in dieser Vorrichtung.**

(57) Bei einem Verfahren zum Prüfen des Betriebszustands eines elektrischen Energiespeichers von Kraftfahrzeugen wird dieser für eine kurze Prüfzeit über eine Prüflast mit konstanter Stromstärke entladen und der für den Betriebszustand aussagekräftige Spannungszustand zu definierten Prüfzeitpunkten mit vorgegebenen Referenzwerten verglichen.

Eine zugehörige Vorrichtung ermöglicht, das Verfahren mit Hilfe einer Baueinheit durchzuführen, die eine entsprechende Schaltung beinhaltet und in die Zigarettenanzünder-Aufnahme des Kraftfahrzeugs einsteckbar ist.

FIG. 3

EP 0 377 094 A1

## Vorrichtung zum Prüfen des Betriebszustands eines elektrischen Energiespeichers von Kraftfahrzeugen und Verfahren zur Verwendung in dieser Vorrichtung

Die Erfindung bezieht sich auf eine Vorrichtung zum Prüfen des Betriebszustands eines elektrischen Energiespeichers von Kraftfahrzeugen, der einer Prüfbelastung unterzogen wird sowie ferner auf ein Verfahren, das in dieser Vorrichtung verwendet wird.

Elektrische Energiespeicher von Kraftfahrzeugen besitzen die unerwünschte und unangenehme Eigenschaft, daß sie unvorhersehbar und in der Regel zum unrechten Zeitpunkt ausfallen. Insbesondere zur Winterzeit macht sich diese Eigenschaft besonders unangenehm bemerkbar.

Insbesondere in Werkstätten ist es vielfach erwünscht, den Zustand des Energiespeichers auf möglichst einfache Weise zu überprüfen. Hierzu ist es bekannt, den Energiespeicher abzuklemmen oder sogar aus dem Kraftfahrzeug auszubauen. Es ergibt sich von selbst, daß dies nur mit erheblichem Aufwand möglich ist. Das Ziel, eine möglichst große Anzahl von Energiespeichern mit möglichst geringem Aufwand zu überprüfen, wird nicht erreicht.

Der Erfindung liegt die Aufgabe zugrunde, eine Vorrichtung der eingangs genannten Art zu schaffen, die auf einfache Weise eine zuverlässige Aussage über den Betriebszustand eines elektrischen Energiespeichers ermöglicht. Ferner hat sich die Erfindung zum Ziel gesetzt, ein Verfahren zu schaffen, das im Rahmen dieser Vorrichtung eine besonders genaue Aussage über den Zustand des Energiespeichers liefert.

Die Erfindung löst diese Aufgabe für die Vorrichtung durch die kennzeichnenden Merkmale des Patentanspruchs 1, für das Verfahren durch die kennzeichnenden Merkmale des Patentanspruchs 5.

Grundlegend für die erfindungsgemäße Vorrichtung ist die leichte Handhabbarkeit der Vorrichtung, die schnell anstelle des üblichen Einsatzes in die Aufnahme eines Zigarettenanzünders eingesetzt werden kann. Durch eine geeignet gewählte schaltungstechnische und konstruktive Ausbildung ist es dabei möglich, die Vorrichtung am Energiespeicher anzuschließen und einer Prüfbelastung zu unterziehen. Der Zigarettenanzünder besitzt den Vorteil, daß er in der Regel eine direkte Verbindung mit dem Energiespeicher besitzt und somit ohne besondere vorbereitende Maßnahme eine Bestimmung des Spannungszustands des Energiespeichers ermöglicht. Darüber hinaus ist mit Hilfe der erfindungsgemäßen Vorrichtung dann die Möglichkeit gegeben, während längerer Standzeiten des Kraftfahrzeugs in einer Reparaturwerkstatt oder dergleichen gleichzeitig und ohne zusätzlichen Aufwand den Betriebszustand des Energiespeichers zu bestimmen und somit in Verbindung mit anderen Servicemaßnahmen eine Aussage über dessen Zustand zu gewinnen.

Eine derartige Vorrichtung kann auf unterschiedliche Weise gestaltet werden. Besonders vorteilhaft zeigt sie sich dann, wenn sie einen Wärmespeicher enthält, der in wärmeleitender Verbindung mit einer Prüflast steht, über die der Energiespeicher einer Hochstrombelastung unterzogen wird. Auf diese Weise ist es möglich, ohne die Gefahr einer Schädigung diese Hochstrombelastung durchzuführen und dabei die entstehende Wärme schnell und sicher abzuführen. Das hierzu besonders vorteilhafte Verfahren ist weiter unten näher erläutert.

Weitere Möglichkeiten, diese Vorrichtung zu gestalten, bestehen darin, zusätzliche Anzeigeelemente in der Baueinheit vorzusehen, die den Betriebszustand des Energiespeichers nach außen hin sichtbar signalisieren. Daneben ist es auch möglich, zusätzlich oder alternativ Mittel zur Fernübertragung von Informationen über den Betriebszustand in der Baueinheit vorzusehen. Diese Mittel können bspw. eine Infrarot-Sendediode oder einen anderen drahtlosen Sender enthalten.

Zusätzlich kann mit den Informationen über den Betriebszustand des Energiespeichers auch eine individuelle Information, bspw. eine Auftragsnummer oder dergleichen übertragen werden und damit eine Identifizierung des Kraftfahrzeugs ermöglicht werden. Es ist dann sogar möglich, anstelle der in Werkstätten üblichen selbsthaftenden und in der Regel auf dem Fahrzeugdach anzuordnenden Auftragsnummer lediglich eine derartige Vorrichtung in den Zigarettenanzünder einzustecken und den Standort des Kraftfahrzeugs und den Betriebszustand des Energiespeichers sowie ggf. weitere Informationen mittels Fernübertragung zu bestimmen. Im Anschluß an eine Reparatur-Auftragannahme hat der Kunde anstelle der üblichen Nummer lediglich eine erfindungsgemäße Vorrichtung im Zigarettenanzünder einzustecken. Neben dem verbesserten optischen Erscheinungsbild läßt sich damit auch die Beschädigungsgefahr des Kraftfahrzeugs vermeiden.

Für ein im Rahmen der Erfindung zur Anwendung kommendes besonders vorteilhaftes Verfahren ist als Ausgangspunkt wesentlich, daß bereits auf vielfältige Weise versucht wurde, den Betriebszustand des elektrischen Energiespeichers zu überprüfen. Es existieren Überlegungen, die Beanspruchungen des Energiespeichers sowohl hinsichtlich Dauer als auch hinsichtlich Intensität festzuhalten und anhand eines entsprechenden auf diese Weise gewonnenen Protokolls und dem Vergleich mit einem Standardprotokoll auf den Betriebszustand und die Wahrscheinlichkeit eines Ausfalls des Energiespeichers zu schließen. Ein derartiges Verfahren ist besonders aufwendig und, wie die Erfahrung gezeigt hat, auch sehr unzuverlässig.

Ferner ist es bekannt, den Zustand des Energiespeichers während einer Prüfbelastung zu überprüfen. So soll der Zustand des Energiespeichers anhand des Anlasserstroms, d. h. des während eines Anlaßvorgangs gelieferten Stroms, überprüfbar sein. Auch dieses Verfahren ist wenig aussagekräftig.

Das im Patentanspruch 5 angegebene Verfahren ermöglicht es, den Zustand des Energiespeichers schnell und zuverlässig zu bestimmen. Grundlegend hierfür ist die Maßnahme, den Energiespeicher kurzzeitig einer extremen Belastung zu unterziehen und nicht nur während dieser Belastung, sondern auch im Anschluß daran den Betriebszustand, d. h. den Spannungszustand des Energiespeichers zu überprüfen. Es hat sich dabei gezeigt, daß es bereits ausreichend ist, nicht während, sondern erst nach der Belastung diesen Betriebszustand zu überprüfen. Durch den Vergleich mit Referenzwerten läßt sich dann eine zuverlässige Aussage gewinnen. Diese Aussage besteht nicht nur im Verhalten des Energiespeichers während der Prüfbelastung, sondern auch im Anschluß daran. Dabei ist von Bedeutung, daß auch das Erholungsverhalten des Energiespeichers Rückschlüsse auf seinen Betriebszustand zuläßt.

Verbesserungen des erfindungsgemäßen Verfahrens sind Gegenstand der Patentansprüche 6 bis 10. Im einzelnen bestehen diese Verbesserungen für Patentanspruch

6 in der Vermeidung von Einflüssen, die durch die mit dem Ein- und Ausschalten verbundenen, von Kraftfahrzeug zu Kraftfahrzeug verschiedenen Schwingungsvorgänge verbunden sind,

7 in der einfachen Gewinnung von Referenzwerten,

8 in der Erhöhung der Aussagekraft durch Wiederholung der Prüfzyklen,

9 in einer deutlichen Verbesserung der Aussagekraft durch Eliminieren eines wesentlichen Einflußfaktors und

10 in der schnellen und zuverlässigen Anzeige dieses Betriebszu stands.

Die Verbesserungen der Erfindung gemäß den Patentansprüchen 7 bis 10 beruhen darauf, den Prüfzyklus zu wiederholen und unter vergleichbaren Bedingungen vergleichbare Werte für den Spannungszustand des Energiespeichers zu gewinnen. Damit können Störeinflüsse durch unzureichende Kontaktierung einer entsprechenden Prüfvorrichtung oder dergleichen völlig ausgeschaltet werden. Die Gewinnung der Referenzwerte mit Hilfe des zu prüfenden Energiespeichers selbst bietet darüber hinaus den Vorteil, daß auch fertigungstechnische Unterschiede des jeweiligen Energiespeichers nicht ins Gewicht fallen.

Das Verfahren nach dem Patentanspruch 8, d. h. die Erhöhung der Aussagekraft durch Wiederholung der Prüfzyklen besitzt gerade in Verbindung mit dem konstruktiven Merkmal des Patentanspruchs 2, d. h. der Anordnung eines Wärmespeichers besondere Bedeutung. Durch den relativ großen zeitlichen Abstand der verschiedenen Prüfzyklen in Verbindung mit der durch den Wärmespeicher sichergestellten Abführung der während der Prüfbelastung entstehenden Wärme wird Sorge getragen, daß der Wärmespeicher stets seine nur von der Außentemperatur abhängige Ausgangstemperatur zu Beginn des Prüfzyklus besitzt und damit die jeweils anfallende Wärme wieder vollständig aufnehmen kann.

In der Zeichnung ist ein Ausführungsbeispiel der Erfindung dargestellt. Es zeigt

Fig. 1 den Schaltungsaufbau für das erfindungsgemäße Verfahren

Fig. 2 ein Diagramm zur Erläuterung der Wirkungsweise des erfindungsgemäßen Verfahrens und

Fig. 3 eine Vorrichtung für das erfindungsgemäße Verfahren.

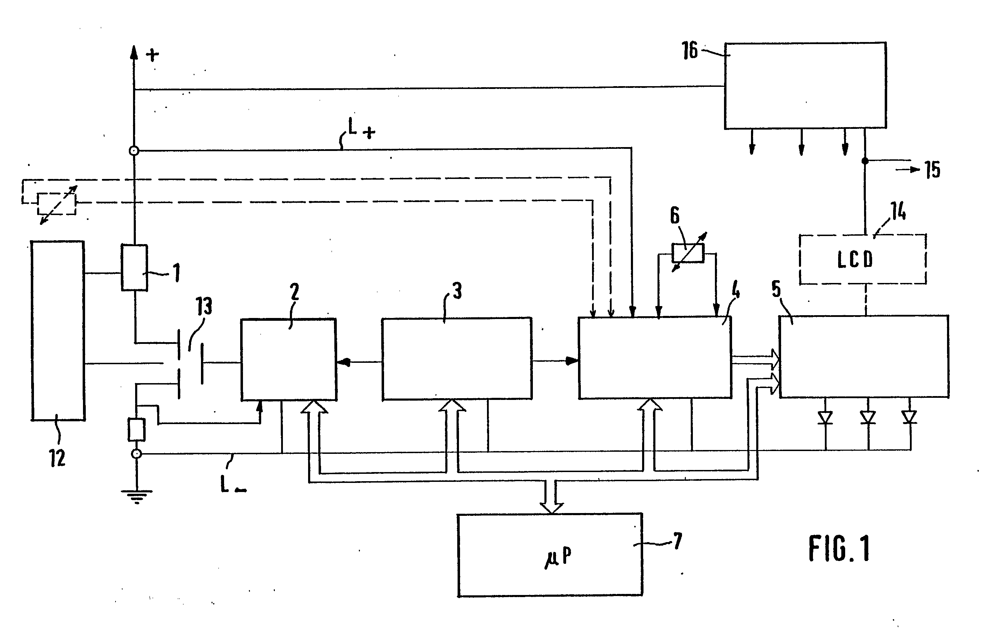

Die in Fig. 1 dargestellte Schaltung dient dazu, den Betriebszustand eines elektrischen Energiespeichers eines Kraftfahrzeugs zu überprüfen. Der Energiespeicher ist in Form seiner beiden Pole dargestellt.

Diese Pole sind mit Plus ( + ) und dem Massesymbol gekennzeichnet.

Der Betriebszustand wird im Rahmen der Erfindung durch eine kurzzeitige, relativ hohe Belastung geprüft. Hierzu dient ein Lastwiderstand 1 und/oder eine Konstant-Stromquelle 2, die so geregelt ist, daß der zwischen den beiden Polen des Energiespeichers fließende Strom einen relativ hohen, konstanten Wert besitzt. Im einzelnen soll dieser Strom bspw. 20 Ampere betragen und für eine Zeit von 0,1 Sekunden wirksam sein. Hierzu dient eine Zeitsteuerung 3, die die Konstant- Stromquelle 2 für diese Zeit einschaltet. Der Betriebszustand des Energiespeichers während dieser Prüfbelastung und im Anschluß daran wird anhand des Spannungszustandes (Leitungen L+ und L-) mit Hilfe eines Analog-/Digital-Wandlers 4 überprüft und einer nachgeschalteten Anzeigesteuerung 5 zugeführt.

Der Wandler 4 ist zusätzlich als Multiplexer ausgebildet und bestimmt die Außentemperatur, symbolisch durch einen Widerstand 6 dargestellt, und führt deren Wert ebenfalls digitalisiert einem Mikroprozessor 7 zu. Der Mikroprozessor 7 steuert die Quelle 2, die Zeitsteuerung 3, den Wandler 4 sowie die Anzeigesteuerung 5. Hierzu besitzt der Mikroprozessor 7 gespeicherte oder mit Hilfe eines vorangegangenen Prüfzyklus gewonnene Referenzwerte für den Spannungszustand des Energiespeichers und zu definierten Prüfzeitpunkten.

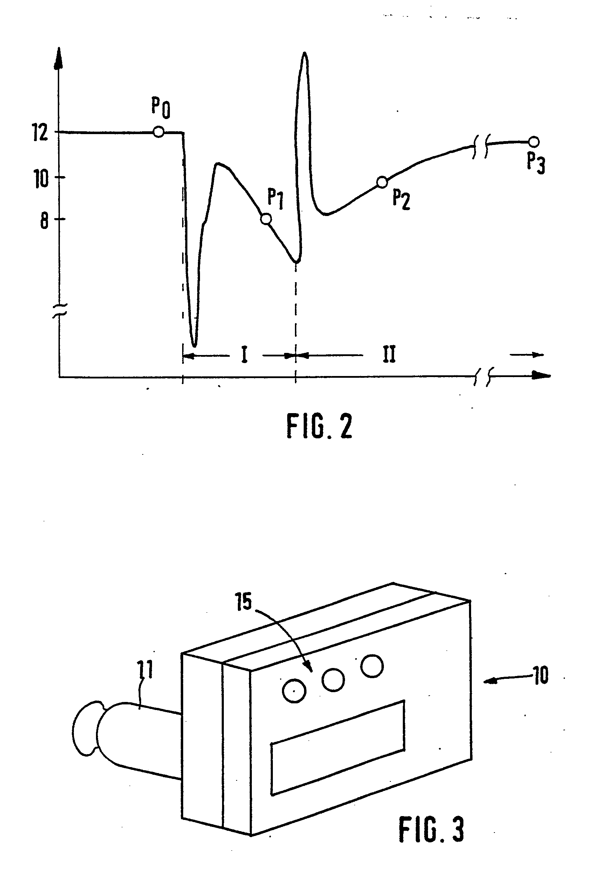

Hierzu sei auf Fig. 2 verwiesen, in der schematisch der Spannungsverlauf des Energiespeichers während eines Prüfzyklus dargestellt ist.

Der Prüfzyklus besitzt eine erste Phase I, in der der Energiespeicher kurzzeitig eingeschaltet ist und der, wie ausgeführt, eine Länge von 0,1 sec. besitzt. In einer zweiten Phase II, der sog. Erholungsphase, ist die Prüfbelastung ausgeschaltet, der Energiespeicher erreicht bei ordnungsgemäßem Zustand wiederum in etwa sein Spannungs-Ausgangsniveau von vorliegend 12 Volt. Deutlich ist zu erkennen, daß beim Ein-und Ausschalten der Prüfbelastung ein Schwingvorgang auftritt. Dieser ist bedingt durch die von Kraftfahrzeug zu Kraftfahrzeug verschiedenen Leitungskapazitäten. Um den unerwünschten Einfluß dieser Kapazitäten auf das Ergebnis der Prüfung zu eliminieren, ist durch entsprechende Wahl der Prüfzeitpunkte dafür gesorgt, daß die Bestimmung des Spannungszustands außerhalb dieser Schwingvorgänge erfolgt.

Die Prüfzeitpunkte sind mit P 1 bis P 3 bezeichnet. Ferner ist ein vorbereitender Spannungszustand, der zum Zeitpunkt P 0 vor Beginn der Prüfbelastung bestimmt wird, eingezeichnet. Neben der Bestimmung von drei Spannungszuständen zu den Zeiten P 1 bis P 3 ist selbstverständlich auch eine beliebige Anzahl von Prüfzeitpunkten möglich. Die dargestellten drei Prüfzeitpunkte haben sich jedoch aufgrund längerer Versuchsreihen als besonders aussagekräftig und ausreichend erwiesen.

Die Spannungswerte zu den Zeiten P 0 bis P 3 sind im Mikroprozessor 7 vorgegeben bzw. werden alternativ beim ersten Prüfzyklus bestimmt. Im letzteren Fall können diese Werte durch einen folgenden Prüfzyklus überschrieben werden bzw. auch für sämtliche weitere Prüfzyklen als Referenzwerte festgehalten werden.

Wesentlich für die Erfindung ist, daß die Spannungswerte zu den Prüfzeitpunkten P 1 bis P 3 bereits bei einer ersten Durchführung des Prüfzyklus eine relativ zuverlässige Aussage über den Betriebszustand des Energiespeichers liefern. Diese Aussage kann durch folgende Prüfzyklen erhärtet werden. Dabei ist die Veränderung der Spannungswerte zu den entsprechenden Zeiten P 1 bis P 3 ein starkes Indiz dafür, daß sich der Energiespeicher dem Ende seiner Lebenszeit nähert. Diese Aussage ist insbesondere dann richtig, wenn sonstige Einflüsse, z. B. aufgrund großer Schwankungen der Außentemperatur, wie dargestellt, eliminiert werden.

Bei einer Abwandlung des beschriebenen Verfahrens wird der Energiespeicher zusätzlich, z. B. bei jedem zweiten Prüfzyklus, oder alternativ bei jedem Prüfzyklus einer Prüfbelastung mit definiert variabler Stromstärke unterzogen. Der Vergleich mit zugehörigen Referenzwerten und die Aussage über die Qualität des Energiespeichers erfolgt entsprechend.

Die in Fig. 3 dargestellte Vorrichtung, mit deren Hilfe das Verfahren auf besonders einfache Weise durchgeführt werden kann, besteht aus mehreren Teilen, die zu einer Baueinheit 10 zusammengefaßt sind. Die Baueinheit 10 enthält einen Anschluß 11, der in eine nicht dargestellte Zigarettenanzünder-Aufnahme einsteckbar ist und damit eine in der Baueinheit 10 enthaltene Schaltung gemäß Fig. 1 am Energiespeicher anschließt. Die Baueinheit 10 enthält ferner einen Wärmespeicher 12, der schematisch in Fig. 1 gezeigt ist und bspw. als Aluminiumblock ausgebildet ist. Der Wärmespeicher 12 steht in wärmeleitender Verbindung mit dem Lastwiderstand 1 bzw. mit dem durch die Konstant-Stromquelle 2 gesteuerten Stromventil 13, bei dem es sich bspw. um einen FET-Transistor handeln kann. Der Wärmespeicher 12 nimmt somit die während der Prüfbelastung entstehende Wärme auf und schützt damit den Lastwiderstand 1 bzw. das Stromventil 13 vor thermischer Zerstörung.

Ist, wie oben beschrieben, eine Wiederholung des Prüfzyklus in gewissem zeitlichen Abstand, z. B. von einer Stunde, vorgesehen, so hat der Wärmespeicher 12 bis dahin die aufgenommene Wärme wieder vollständig an die Umgebung abgegeben und steht für eine erneute Wärmeaufnahme zur Verfügung.

Die Baueinheit 10 enthält ferner eine Flüssigkristall(LCD)-Anzeige 14 (vgl. Fig. 1) bzw. eine LED-Anzeige 15, die aus 3 Leuchtdioden mit unterschiedlicher Farbe besteht. Anhand des Leuchtzustands der Leuchtdioden, von denen jeweils eine eingeschaltet ist, ist ohne weiteres und auch außerhalb des Kraftfahrzeugs der Betriebszustand des Energiespeichers zu erkennen. Die Stromversorgung der Anzeige 14 bzw. 15 erfolgt mit Hilfe eines Speichers 16, der ebenfalls in Fig. 1 schematisch dargestellt ist. Dabei ist die Arbeitsweise der Anzeigesteuerung 5 so gewählt, daß die erste Leuchtdiode der Anzeige 15 mit bspw. grüner Farbe dann leuchtet, wenn die Spannungswerte zu den Prüfzeitpunkten P 1 bis P 3 innerhalb einer vorgegebenen Toleranz mit den vorgegebenen Spannungswerten für die entsprechenden Prüfzeitpunkte übereinstimmen und auch bei einem nachfolgenden Prüfzyklus diese Übereinstimmung erhalten bleibt.

Die zweite Leuchtdiode mit bspw. gelber Farbe leuchtet dann auf, wenn einer der Spannungswerte zwar außerhalb des für die grüne Leuchtdiode maßgeblichen Toleranzbandes, jedoch innerhalb eines weiteren Toleranzbandes mit größerer Breite liegt.

Schließlich leuchtet die rote Leuchtdiode, wenn mindestens zu einem der Prüfzeitpunkte der Spannungswert mehr als durch das für die zweite Leuchtdiode maßgebliche Toleranzband vom vorgegebenen Spannungswert abweicht.

Neben der optischen Anzeige des Betriebszustands des Energiespeichers mit Hilfe der Anzeige 14 bzw. 15 ist es zusätzlich oder alternativ möglich, den Spannungszustand auch mit Hilfe einer Fernübertragung auf eine entsprechende Empfangseinrichtung, bspw. in einer Kundendienstzentrale, zu übertragen. Dort wird somit der Spannungszustand der in Fig. 3 dargestellten Baueinheit versehenen Kraftfahrzeuge festgestellt. Entsprechende Servicemaßnahmen können dann zentral eingeleitet werden.

## Ansprüche

1. Vorrichtung zum Prüfen des Betriebszustands eines elektrischen Energiespeichers von Kraftfahrzeugen, der einer Prüfbelastung unterzogen wird, dadurch gekennzeichnet, daß die Vorrichtung als kompakte und demontierbare Baueinheit ausgebildet ist, die in eine Zigarettenanzünder-Aufnahme einsetzbar und im eingesetzten Zustand am Energiespeicher anschließbar bzw. angeschlossen ist.

2. Vorrichtung nach Anspruch 1, dadurch gekennzeichnet, daß die Baueinheit einen Wärmespeicher für die während eines Prüfzyklus anfallende Wärme enthält, der in wärmeleitender Verbindung mit einer während der Prüfung des Energiespeichers eingeschalteten Prüflast steht.

3. Vorrichtung nach Anspruch 1 oder 2, dadurch gekennzeichnet, daß die Baueinheit zusätzliche den Betriebszustand des Energiespeichers signalisierende Anzeigeelemente enthält.

4. Vorrichtung nach einem der Ansprüche 1 bis 3, dadurch gekennzeichnet, daß zusätzliche Mittel zur Fernübertragung von für den Betriebszustand des Energiespeichers charakteristischen Informationen in der Baueinheit enthalten sind.

5. Verfahren zum Prüfen des Betriebszustands eines elektrischen Energiespeichers von Kraftfahrzeugen, mit Hilfe einer Vorrichtung nach einem Ansprüche 1 bis 4, dadurch gekennzeichnet, daß der Energiespeicher für eine kurze Prüfzeit über eine Prüflast entladen wird, daß die Prüfbelastung mit konstanter und/oder definiert variabler Stromstärke durchgeführt wird, daß der Spannungszustand des Energiespeichers während eines definierten und über die Prüfzeit hinausreichenden Prüfzyklus zu definierten Prüfzeitpunkten geprüft wird und daß der Spannungszustand mit vorgegebenen Referenzwerten verglichen wird.

6. Verfahren nach Anspruch 5, dadurch gekennzeichnet, daß der Spannungszustand außerhalb der durch Ein- und Ausschalten der Prüfbelastung bedingten elektrischen Ein- und Ausschwingvorgänge geprüft wird.

7. Verfahren nach Anspruch 5 oder 6, dadurch gekennzeichnet, daß die Referenzwerte durch mindestens einen vorangegangenen Prüfzyklus gewonnen werden.

8. Verfahren nach einem der Ansprüche 5 bis 7, dadurch gekennzeichnet, daß der Prüfzyklus in gegenüber der Dauer des Prüfzyklus wesentlich größerem zeitlichen Abstand wiederholt wird.

9. Verfahren nach einem der Ansprüche 5 bis 8, dadurch gekennzeichnet, daß zusätzlich die Außentemperatur berücksichtigt wird.

10. Verfahren nach einem der Ansprüche 5 bis 9, dadurch gekennzeichnet, daß die Anzeigeelemente vom Ergebnis des Vergleichs mit den Referenzwerten abhängige Anzeigeelemente gesteuert werden, die in der Baueinheit enthalten sind.

FIG.1

FIG. 2

FIG. 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| Y | PATENT ABSTRACTS OF JAPAN, Band 228, Nr. 8, (P-308), 19. Oktober 1984; & JP-A-59 108 969 (TOUKIYOU TATSUNO K.K.) 23-06-1984 --- | 1,4 | G 01 R 31/00 G 01 R 31/36 |
| Y | IEEE IECON '83, PROCEEDINGS ANNUAL CONFERENCE ON INDUSTRIAL ELECTRONICS, 7-11 November 1983, Hyatt Regency Hotel, San Francisco, US; Seiten 123-128; R.C ALFORD: "Universal microcomputer electrical testing system II (Unimets II)" * Seite 123, linke Spalte; Seite 127, Absatz: "The future" * --- | 1,4 | |
| A | ELECTRONIC ENGINEERING, Band 57, Nr. 705, September 1985, Seiten 26-27; C. CUNNINGHAM: "Sealed lead-acid battery tester" * Seite 26, Spalten 1,2 * --- | 2 | |
| A | US-A-4 027 231 (D.R. LOHRMANN) * Zusammenfassung * --- | 3,9,10 | **RECHERCHIERTE SACHGEBIETE (Int. Cl.5)** <br> G 01 R |
| A | DE-B-2 610 536 (SIEMENS A.G.) * Spalte 3, Zeile 34 - Spalte 5, Zeile 1 * --- | 5,6 | |
| A | DE-A-3 108 844 (SIEMENS A.G.) * Zusammenfassung * --- | 5,6 | |
| A | EP-A-0 004 382 (ACCUMULATORENFABRIK SONNENSCHEIN GmbH) * Seite 2, Zeilen 1-16 * ---      -/- | 7 | |

Der vorliegende Recherchenbericht wurde für alle Patentansprüche erstellt

| Recherchenort | Abschlußdatum der Recherche | Prüfer |
|---|---|---|
| DEN HAAG | 16-03-1990 | LUT K. |

EPO FORM 1503 03.82 (P0403)

## EUROPÄISCHER RECHERCHENBERICHT

**Europäisches Patentamt**

### EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | EP-A-0 204 163 (ACCUMULATORENFABRIK SONNENSCHEIN GmbH) * Patentanspruch 5 * ----- | 8 | |

RECHERCHIERTE SACHGEBIETE (Int. Cl.5)

Der vorliegende Recherchenbericht wurde für alle Patentansprüche erstellt

| Recherchenort | Abschlußdatum der Recherche | Prüfer |
|---|---|---|
| DEN HAAG | 16-03-1990 | LUT K. |